# EUROPÄISCHE PATENTANMELDUNG

(11) **EP 3 572 567 A1**
(43) Veröffentlichungstag der Anmeldung: **27.11.2019**
(21) Anmeldenummer: 19173546.3
(22) Anmeldetag: 09.05.2019
(51) Int. Cl.: D01H 1/16, B65H 54/00

(54) **TEXTILMASCHINE MIT EINER KÜHLANORDNUNG**

(30) Priorität: 25.05.2018 DE 102018112620
(71) Anmelder: Maschinenfabrik Rieter AG, 8406 Winterthur (CH)
(72) Erfinder: Bahlmann, Bernd, 86529 Schrobenhausen (DE); Maleck, Mario, 85137 Walting (DE); Renner, Philipp, 85098 Großmehring (DE); Sippl, Stefan, 85051 Ingolstadt (DE)
(74) Vertreter: Bergmeier, Werner

(57) **Zusammenfassung**

Eine Textilmaschine (1), insbesondere Rotorspinnmaschine, weist eine Vielzahl an nebeneinander angeordneten Arbeitsstellen, insbesondere Spinn- und/oder Spulstellen auf, welche zu mehreren Sektionen (2a - 2f) zusammengefasst sind. Weiter weist die Textilmaschine (1) mehrere elektrische Versorgungseinheiten (3a - 3f) auf, mittels welcher die Arbeitsstellen und/oder die Sektionen (2a - 2f) mit elektrischer Energie versorgbar sind, und eine zumindest einen Kühlmittelkreislauf (16a - 16c) umfassende Kühlanordnung (4), mittels der eine Abwärme der elektrischen Versorgungseinheiten (3a - 3f) aufnehmbar und zu einem Abgabebereich (5) der Textilmaschine (1) transportierbar ist. Die Kühlanordnung (4) ist derart ausgebildet, dass mittels des wenigstens einen Kühlmittelkreislaufs (16a - 16c) die Abwärme mehrerer der elektrischen Versorgungseinheiten (3a - 3f) zu einem gemeinsamen Abgabebereich (5) der Textilmaschine (1) transportierbar ist.

## Beschreibung

Die vorliegende Erfindung betrifft eine Textilmaschine mit einer Vielzahl an nebeneinander angeordneten Arbeitsstellen, insbesondere Spinn- und/oder Spulstellen, welche zu mehreren Sektionen zusammengefasst sind, wobei die Textilmaschine mehrere elektrische Versorgungseinheiten aufweist, mittels denen die Arbeitsstellen und/oder Sektionen mit elektrischer Energie versorgbar sind. Die Textilmaschine weist zumindest eine Kühlanordnung auf, mittels der eine Abwärme der elektrischen Versorgungseinheiten aufnehmbar ist und zu einem Abgabebereich der Textilmaschine transportierbar ist.

Aus der EP 0 326 688 B1 ist eine Textilmaschine bekannt, bei der die Spindeln, die Motoren und deren Energieversorgungen mittels mehrerer Kühlkreisläufe gekühlt werden. Die Kühlkreisläufe transportieren die Abwärme in einen sich längs der Textilmaschine erstreckenden, ohnehin vorhandenen Absaugkanal, wo die Wärme an die dort strömende Luft abgegeben wird.

Aufgabe der vorliegenden Erfindung ist es, die Kühlung der Textilmaschine zu verbessern.

Die Aufgabe wird gelöst durch eine Textilmaschine mit den Merkmalen des unabhängigen Patentanspruchs.

Vorgeschlagen wird eine Textilmaschine, insbesondere Rotorspinnmaschine, mit einer Vielzahl an in einer Längsrichtung der Textilmaschine nebeneinander angeordneten Arbeitsstellen, wobei die Arbeitsstellen Spinn- und/oder Spulstellen sein können, welche zu mehreren Sektionen zusammengefasst sind. Entsprechend der Anzahl an Arbeitsstellen kann die Produktivität der Textilmaschine erhöht werden. Handelt es sich bei den Arbeitsstellen beispielsweise um Spinnstellen, kann mit deren Hilfe ein Garn hergestellt werden.

Ferner umfasst die Textilmaschine mehrere elektrische Versorgungseinheiten zur Bereitstellung elektrischer Energie. Mit Hilfe der elektrischen Versorgungseinheiten können die Arbeitsstellen und/oder die Sektionen mit elektrischer Energie versorgt werden. Dabei kann jeder Arbeitsstelle eine elektrische Versorgungseinheit zugeordnet sein. Zusätzlich oder alternativ kann eine elektrische Versorgungseinheit auch eine Sektion aus mehreren Arbeitsstellen mit elektrischer Energie versorgen.

Da eine elektrische Versorgungseinheit stets eine Verlustleistung aufweist, die in Abwärme umgesetzt wird, weist die Textilmaschine eine zumindest einen Kühlmittelkreislauf umfassende Kühlanordnung auf, mittels der die Abwärme der elektrischen Versorgungseinheiten aufnehmbar ist und zu einem Abgabebereich der Textilmaschine transportierbar ist. Die elektrischen Versorgungseinheiten werden dadurch gekühlt bzw. auf einer gleichmäßigen Temperatur gehalten, so dass diese vor Beschädigung durch Überhitzung geschützt werden.

Erfindungsgemäß ist die Kühlanordnung derart ausgebildet, dass mittels des wenigstens einen Kühlmittelkreislaufs die Abwärme mehrerer der elektrischen Versorgungseinheiten zu einem gemeinsamen Abgabebereich der Textilmaschine transportierbar ist. Im Kühlmittelkreislauf kann beispielsweise Wasser als Kühlmittel zirkulieren, welches die Abwärme der elektrischen Versorgungseinheiten aufnimmt und abtransportiert. Dadurch kann die Abwärme im Abgabebereich gesammelt und von dort an die Umwelt abgegeben werden.

Der Abgabebereich ist vorteilhafterweise innerhalb der Textilmaschine, vorzugsweise an einem der beiden Enden der Textilmaschine angeordnet. Zusätzlich oder alternativ ist es jedoch auch möglich, den Abgabebereich oder einen weiteren Abgabebereich außerhalb der Textilmaschine vorzusehen. Beispielsweise könnte die Textilmaschine auch einen Anschluss aufweisen, mittels welchem ein im Kühlmittelkreislauf zirkulierendes Kühlmittel aus der Textilmaschine ausleitbar ist. Dabei kann es auch vorteilhaft sein, das Kühlmittel aus einem Saal, in welchem die Textilmaschine angeordnet ist, herrauszuleiten, um es außerhalb des Saales rückzukühlen. Beispielsweise könnte das Kühlmittel auch bis auf ein Dach eines Gebäudes, in dem die Textilmaschine steht, geführt werden, um die Wärme dort abzugeben. Da die Räume, in denen solche Textilmaschinen stehen, meist klimatisiert sind, kann durch einen Abgabebereich außerhalb des Gebäudes eine übermäßige Belastung der Klimaanlage vermieden werden. Denkbar wäre es weiterhin auch, das mit der Abwärme beladene Kühlmittel einem Heizsystem des Gebäudes zuzuführen. Auch in diesem Fall befindet sich der Abgabebereich außerhalb der Maschine.

In einer vorteilhaften Weiterbildung der Erfindung ist im Abgabebereich ein Wärmetauscher der Kühlanordnung angeordnet, mittels dem die Abwärme an eine Umgebung der Textilmaschine abgebbar ist. Der Wärmetauscher kann beispielsweise als Kühler ausgebildet sein, so dass die Wärme an die Umgebungsluft abgegeben werden kann. Die Abgabe der Abwärme an die Umgebungsluft kann ferner von einem Lüfter unterstützt werden.
Wenn die Textilmaschine eine gewisse Länge aufweist, kann es vorteilhaft sein, wenn die Textilmaschine zumindest zwei Abgabebereiche aufweist, so dass die Abwärme nur über kurze Strecken zum Abgabebereich transportiert werden muss. Die Abgabebereiche können beispielsweise entlang der Textilmaschine beabstandet angeordnet sein.

Vorteilhaft ist es daher auch, wenn im Abgabebereich ein Abführkanal angeordnet ist. Die Abwärme kann mittels des Abführkanals aus der Textilmaschine abgeführt werden, ohne an die Umgebung abgegeben zu werden und diese entsprechend aufzuheizen. Ist die Textilmaschine beispielsweise in einem klimatisierten Saal angeordnet, so wird durch die Ableitung der Abwärme mittels des Abführkanals die Wärmeabgabe in den Saal vermieden und die Klimaanlage wird dadurch weniger belastet oder kann kleiner dimensioniert werden. Der Abführkanal kann die Abwärme beispielsweise mittels einer Luftströmung abführen.

Denkbar ist es aber auch, dass der Textilmaschine ein externes, also außerhalb der Textilmaschine angeordnetes, Kühlsystem zugeordnet ist und die Abwärme im Abgabebereich an das externe Kühlsystem übergebbar ist. Der Abführkanal ist in diesem Fall Teil des externen Kühlsystems. Das externe Kühlsystem kann dabei ebenfalls als Kühlmittelkreislauf ausgebildet sein. Der wenigstens eine Abgabebereich mit einem Wärmetauscher kann dabei sowohl innerhalb als auch außerhalb der Textilmaschine angeordnet sein. Dabei können vorteilhafterweise auch mehrere Textilmaschinen und ggf. auch andere wärmeerzeugende Anlagen an das externe Kühlsystem angeschlossen sein.

Die elektrischen Versorgungseinheiten beinhalten vorzugsweise Netzteile, Frequenzumrichter und/oder sonstige elektrische Bauteile, die zum Bereitstellen von elektrischer Energie der Arbeitsstellen und/oder der Sektionen benötigt werden.

Nach einer vorteilhaften Ausführung weist jede der Sektionen jeweils eine elektrische Versorgungseinheit, insbesondere ein Netzteil, zur Energieversorgung der jeweiligen Sektion und der ihr zugeordneten Arbeitsstellen auf. Die elektrische Versorgungseinheit weist in diesem Fall natürlich eine entsprechend hohe Leistungsfähigkeit auf, um beispielsweise 20 Arbeitsstellen einer Sektion mit elektrischer Energie versorgen zu können. Die elektrische Versorgungseinheit kann daher eine Leistung von einigen Kilowatt aufweisen, so dass die beschriebene Kühlanordnung für eine solche Ausführung besonders vorteilhaft ist.

Vorteilhafterweise verbindet der zumindest eine Kühlmittelkreislauf alle elektrischen Versorgungseinheiten der Textilmaschine und deren Abwärme ist zu einem einzigen, gemeinsamen Abgabebereich transportierbar. Dadurch kann die Abwärme der elektrischen Versorgungseinheiten in jeder einzelnen Sektion aufgenommen und zu dem zentralen Abgabebereich abtransportiert werden. Eine Erwärmung von Teilen der Textilmaschine wird hierdurch vermieden.

Zusätzlich oder alternativ ist es von Vorteil, wenn der Abgabebereich an einem ersten Ende der Textilmaschine, insbesondere in einem ersten Endgestell, angeordnet ist. Dadurch kann eine Platzbeeinträchtigung der Textilmaschine durch den Abgabebereich beispielsweise durch den Wärmetauscher oder ähnliches vermieden werden. Außerdem kann dort die Abwärme abgeführt werden, ohne umliegende Arbeitsstellen aufzuwärmen, wie es beispielsweise der Fall wäre, wenn der Abgabebereich zwischen zwei Arbeitsstellen angeordnet ist.

Insbesondere wenn es sich um eine längere Textilmaschine handelt, kann es jedoch auch vorteilhaft sein, wenn die Textilmaschine zumindest zwei Abgabebereiche aufweist, wobei vorzugsweise ein Abgabebereich an dem ersten Ende der Textilmaschine, insbesondere in einem ersten Endgestell der Textilmaschine, und ein Abgabebereich an einem zweiten Ende der Textilmaschine, insbesondere in einem zweiten Endgestell der Textilmaschine, angeordnet ist. Dabei ist es zudem vorteilhaft, wenn auch wenigstens zwei Kühlmittelkreisläufe an der Textilmaschine vorgesehen sind. Dabei können beispielsweise die Arbeitsstellen jeweils einer Maschinenlängsseite an den ersten Kühlmittelkreislauf angeschlossen sein und die Arbeitsstellen der zweiten Maschinenlängsseite an den zweiten Kühlmittelkreislauf angeschlossen sein. Denkbar ist es aber auch, beide Maschinenlängsseiten in jeweils zwei Hälften zu unterteilen und die Arbeitsstellen beider Maschinenlängsseiten der ersten Hälfte an den ersten Kühlmittelkreislauf anzuschließen und die Arbeitsstellen beider Maschinenlängsseiten der zweiten Hälfte an den zweiten Kühlmittelkreislauf.

Vorteilhaft ist es auch, wenn die Kühlanordnung eine Betriebseinheit umfasst. Die Betriebseinheit kann alle zum Betrieb der Kühlanordnung benötigten Elemente umfassen. Die Betriebseinheit kann beispielsweise eine Steuereinheit zum Steuern der Kühlanordnung, eine Pumpe, ein Kühlmittelreservoir, eine Entlüftereinheit und/oder Steuerventile umfassen. Die Betriebseinheit ist vorzugsweise an dem dem Abgabebereich gegenüberliegenden, zweiten Ende der Textilmaschine, insbesondere in einem zweiten Endgestell der Textilmaschine, angeordnet. Somit sind die Betriebseinheit und der Abgabebereich durch den zumindest einen Kühlmittelkreislauf verbunden. Das Kühlmittel kann beispielsweise von der Pumpe der Betriebseinheit durch den Kühlmittelkreislauf und somit zu den elektrischen Versorgungseinheiten gepumpt werden, so dass die Abwärme aufgenommen und zum Abgabebereich transportiert wird. Die Komponenten der Kühlanordnung können hierdurch besonders platzsparend und effektiv in Bezug auf die Kühlleistung untergebracht werden.

Nach einer Weiterbildung der Erfindung weisen die Sektionen und/oder die Arbeitsstellen weitere Abwärmequellen auf, welche an den wenigstens einen Kühlmittelkreislauf angeschlossen sind. Beispielsweise können große Antriebe der Textilmaschine wie Zentralantriebe für bestimmte Funktionseinheiten auf diese Weise an den Kühlmittelkreislauf angeschlossen werden. Es kann somit auch die Abwärme beispielsweise von Antrieben der Arbeitsstellen, insbesondere der Rotorantriebe, ebenfalls effektiv mittels des wenigstens einen Kühlmittelkreislaufs abgeführt werden. Ebenso können elektronische Bauteile, beispielsweise Steuereinrichtungen oder Energieversorgungseinheiten an den einzelnen Arbeitsstellen, an den Kühlmittelkreislauf angeschlossen werden, um die Lebensdauer der elektronischen Bauteile zu verlängern.

Vorteilhaft ist es, wenn die Kühlanordnung mehrere Kühlmittelkreisläufe aufweist, wobei die elektrischen Versorgungseinheiten und/oder die weiteren Abwärmequellen derart an die mehreren Kühlmittelkreisläufe angeschlossen sind, dass eine Abwärmeaufnahme der mehreren Kühlmittelkreisläufe jeweils gleich ist. Dadurch werden die elektrischen Versorgungseinheiten gleichmäßig auf die vorhandenen Kühlmittelkreisläufe verteilt, so dass jeder Kühlmittelkreislauf im Wesentlichen die gleiche Abwärme aufnimmt und abtransportiert. Dadurch wird vermieden, dass ein Kühlmittelkreislauf im Vergleich zu den anderen Kühlmittelkreisläufen deutlich mehr Abwärme aufnimmt und abtransportiert. Die Energieversorgungseinheiten können somit trotz ihrer unterschiedlichen Anordnung innerhalb der Maschine gleichmäßig gekühlt werden.

Von Vorteil ist es außerdem, wenn die Kühlanordnung mehrere Kühlmittelkreisläufe mit der Anzahl N aufweist, wobei mittels des ersten Kühlmittelkreislaufs die Abwärme der 1-ten, der N+1-ten, der 2N+1-ten, der 3N+1-ten, usw. elektrischen Versorgungseinheit aufnehmbar ist, mittels des zweiten Kühlmittelkreislaufs die Abwärme der 2-ten, der N+2-ten, der 2N+2-ten, der 3N+2-ten, usw. elektrischen Versorgungseinheit aufnehmbar ist, mittels des dritten Kühlmittelkreislaufs die Abwärme der 3-ten, der N+3-ten, der 2N+3-ten, der 3N+3-ten, usw. elektrischen Versorgungseinheit aufnehmbar ist, usw.

Weist die Kühlanordnung beispielsweise drei Kühlmittelkreisläufe auf, kann mittels des ersten Kühlmittelkreislaufs die Abwärme der ersten, der vierten, der siebten, der zehnten, usw. elektrischen Versorgungseinheit aufgenommen werden. Mit dem zweiten Kühlmittelkreislauf kann die Abwärme der zweiten, der fünften, der achten, der elften, usw. elektrischen Versorgungseinheit aufgenommen werden. Mit dem dritten Kühlmittelkreislauf kann die Abwärme der dritten, der sechsten, der neunten, der zwölften, usw. elektrischen Versorgungseinheit aufgenommen werden. Dadurch können mit mehreren Kühlmittelkreisläufen die elektrischen Versorgungseinheiten der Textilmaschine gleichmäßig gekühlt werden.

Ferner ist es vorteilhaft, wenn die Kühlmittelkreisläufe mehrere Zuleitungen und eine gemeinsame Rückleitung aufweisen. Dadurch kann die Kühlanordnung einfacher aufgebaut sein.

Von Vorteil ist es, wenn sich die Zuleitung(en) und/oder die Rückleitung entlang der Längsrichtung der Textilmaschine erstrecken. Die Energieversorgungseinheiten können hierdurch nacheinander von dem Kühlmittel durchflossen werden.

Weiterhin ist es vorteilhaft, wenn die elektrischen Versorgungseinheiten jeweils eine vorzugsweise in ein Gehäuse der Versorgungseinheiten integrierte Kühleinheit aufweisen, wobei der wenigstens eine Kühlmittelkreislauf, insbesondere die Zuleitung des wenigstens einen Kühlmittelkreislaufs, durch diese hindurchführt. Die Kühleinheit kann beispielsweise ein Kühler in Form einer Metallplatte und/oder eines Metallblocks sein, der in und/oder an den elektrischen Versorgungseinheiten angeordnet ist und die Abwärme aufnimmt und an das Kühlmittel des Kühlmittelkreislaufs abgibt. Vorzugsweise bildet der Kühler dabei eine Gehäusewand der Energieversorgungseinheit.

Vorzugsweise weist die Kühleinheit einen oder mehrere mäanderförmig ausgebildete Kühlkanäle auf, so dass der Kühlmittelkreislauf mäanderförmig durch die Kühleinheit geführt ist. Das Kühlmittel ist somit länger mit der Kühleinheit in Kontakt und kann dadurch mehr Abwärme aufnehmen. Insbesondere bei Energieversorgungseinheiten, welche die gesamte Sektion mit ihren Arbeitsstellen versorgen und daher eine besonders hohe Leistung aufweisen, ist eine solche Ausführung vorteilhaft.

Weitere Vorteile der Erfindung sind in den nachfolgenden Ausführungsbeispielen beschrieben. Es zeigen:
- **Figur 1**: eine schematische Ansicht einer Textilmaschine mit einer Kühlanordnung für elektrische Versorgungseinheiten mit einem Kühlmittelkreislauf und
- **Figur 2**: eine schematische Ansicht einer Textilmaschine mit einer Kühlanordnung für elektrische Versorgungseinheiten mit mehreren Kühlmittelkreisläufen.

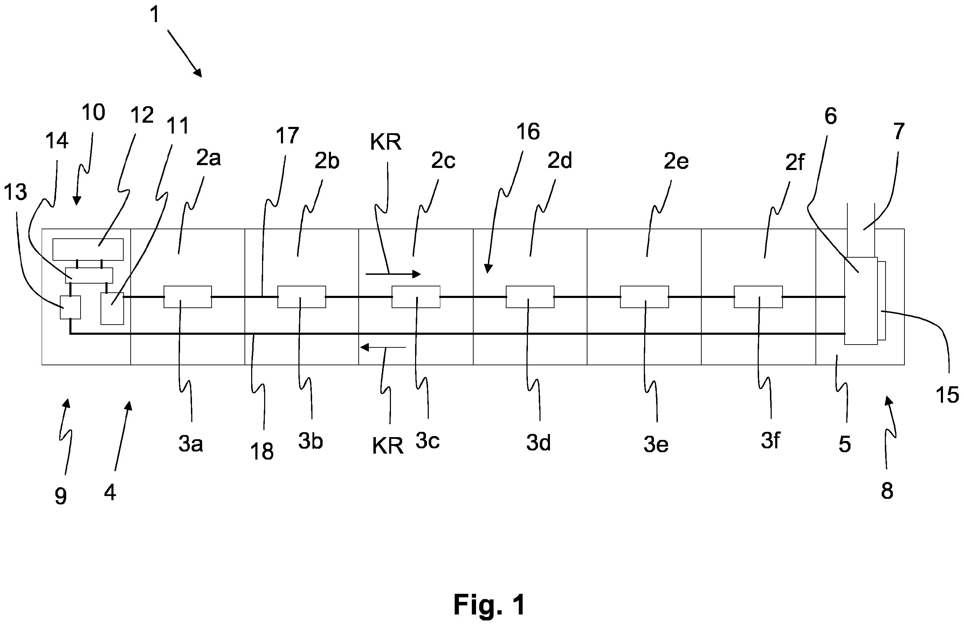

Figur 1 zeigt eine schematische Ansicht einer Textilmaschine 1 mit einer Kühlanordnung 4 für elektrische Versorgungseinheiten 3a - 3f. Die Textilmaschine 1 umfasst eine Vielzahl an Arbeitsstellen, so dass eine Produktivität der Textilmaschine 1 entsprechend der Anzahl der Arbeitsstellen erhöht ist. Bei den Arbeitsstellen kann es sich um Spinn- und/oder Spulstellen handeln, die ein Garn herstellen bzw. behandeln. Die Arbeitsstellen sind im vorliegenden Ausführungsbeispiel zu Sektionen 2a - 2f zusammengefasst, wobei eine Sektion 2a - 2f beispielsweise 20 Arbeitsstellen umfassen kann. Die Textilmaschine 1 des vorliegenden Ausführungsbeispiels weist beispielhaft sechs Sektionen 2a - 2f mit jeweils einer elektrischen Versorgungseinheit 3a - 3f auf. Es sind natürlich auch Textilmaschinen 1 mit mehr Sektionen 2a - 2f und/oder elektrischen Versorgungseinheiten 3a - 3f denkbar.

Gemäß dem vorliegenden Ausführungsbeispiel ist jeder Sektion 2a - 2f eine elektrische Versorgungseinheit 3a - 3f zugeordnet, um die Sektion 2a - 2f mit elektrischer Energie versorgen zu können. Dabei wäre es zusätzlich oder alternativ auch denkbar, dass eine elektrische Versorgungseinheit 3a - 3f auch einer einzigen Arbeitsstelle zugeordnet ist. Die elektrische Versorgungseinheit 3a - 3f kann beispielsweise ein Netzteil, ein Frequenzumrichter, eine Lastelektronik oder ähnliches umfassen, die zur Bereitstellung der elektrischen Energie benötigt werden.

Da gemäß dem vorliegenden Ausführungsbeispiel eine elektrische Versorgungseinheit 3a - 3f eine Sektion 2a - 2f mit beispielsweise 20 Arbeitsstellen mit elektrischer Energie versorgen muss, weist die elektrische Versorgungseinheit 3a - 3f eine entsprechend hohe elektrische Leistung auf, die beispielsweise im Bereich von bis zu 10 Kilowatt liegen kann. Da jede elektrische Versorgungseinheit 3a - 3f eine Verlustleistung aufweist, die 500 Watt oder mehr betragen kann, wird ein Teil der der elektrischen Versorgungseinheit 3a - 3f zugeführten Energie in Abwärme umgesetzt, die zur Erwärmung der elektrischen Versorgungseinheiten 3a - 3f, der Sektionen 2a - 2f und der Textilmaschine 1 führt.

Um eine Überhitzung insbesondere der elektrischen Versorgungseinheiten 3a - 3f zu vermeiden, weist die Textilmaschine 1 die Kühlanordnung 4 auf, mittels der die Abwärme der elektrischen Versorgungseinheiten 3a - 3f zu einem Abgabebereich 5 der Textilmaschine 1 transportierbar ist. Insbesondere kann mit Hilfe der Kühlanordnung 4 die gesamte durch die elektrischen Versorgungseinheiten 3a - 3f erzeugte Abwärme zum Abgabebereich 5 transportiert werden. Beispielsweise kann die Abwärme aller elektrischer Versorgungseinheiten 3a - 3f zum Abgabebereich 5 transportiert werden. Dort kann die gesammelte Abwärme aus der Textilmaschine 1 abgeführt und an die Umgebung abgegeben werden.

Gemäß dem vorliegenden Ausführungsbeispiel ist der Abgabebereich 5 an einem ersten Ende 8 der Textilmaschine 1 angeordnet. Dadurch kann eine Erwärmung der an den Abgabebereich 5 angrenzenden Sektionen 2a - 2f (hier der Sektion 2f) auf ein Minimum reduziert werden.

Im Abgabebereich 5 weist die Kühlanordnung 4 einen Wärmetauscher 6 auf, der die Abwärme von der Kühlanordnung 4 an die Umgebung überführt. An den Wärmetauscher 6 schließt gemäß dem vorliegenden Ausführungsbeispiel ein Abführkanal 7 an, mittels dem die Abwärme beispielsweise aus einem Gebäude, in dem die Textilmaschine 1 steht, abgeführt werden kann.

Am Wärmetauscher 6 kann ferner ein Lüfter 15 angeordnet sein, um den Wärmeaustausch mit der Umgebung zu unterstützen und ggf. die Abwärme gezielt in den Abführkanal 7 überführen zu können.

Die Kühlanordnung 4 weist ferner eine Betriebseinheit 10 auf, die die für den Betrieb der Kühlanordnung 4 benötigten Elemente umfasst. Die Betriebseinheit 10 kann beispielsweise eine Pumpe 11 zum Pumpen eines Kühlmittels, ein Kühlmittelreservoir 12, Steuerventile 13 und/oder einen Luftabscheider 14 umfassen. Vorteilhafterweise ist es mittels der Betriebseinheit 10 möglich, die Kühlanordnung 4 vollständig zu entleeren, um beispielsweise das Kühlmittel oder auch einzelne elektrische Versorgungseinheiten 3a - 3f auszutauschen.

Gemäß dem vorliegenden Ausführungsbeispiel ist die Betriebseinheit 10 an einem zum ersten Ende 8 gegenüberliegenden, zweiten Ende 9 der Textilmaschine 1 angeordnet.

Um die Abwärme transportieren zu können, weist die Kühlanordnung 4 außerdem zumindest einen Kühlmittelkreislauf 16 auf. Mit Hilfe des Kühlmittelkreislaufs 16 kann ein Kühlmittel zu den elektrischen Versorgungseinheiten 3a - 3f transportiert werden, das dort die Abwärme aufnimmt. Das Kühlmittel kann von den elektrischen Versorgungseinheiten 3a - 3f zum Abgabebereich 5 transportiert werden, wo es die Abwärme an die Umgebung abgibt. Das Kühlmittel kann sich bei der Aufnahme der Abwärme an den elektrischen Versorgungseinheiten 3a - 3f selbst erwärmen. Beim Kühlmittel kann es sich vorteilhafterweise um Wasser handeln, da Wasser einfach zu handhaben ist und eine hohe Wärmekapazität aufweist. Alternativ kann als Kühlmittel auch ein Gas in Frage kommen. Zusätzlich oder alternativ kann auch ein Kühlmittel verwendet werden, das die Abwärme als latente Wärme aufnimmt und abtransportiert.

Gemäß dem vorliegenden Ausführungsbeispiel weist das Kühlmittel im Kühlmittelkreislauf 16 eine Strömungsrichtung KR auf. Das Kühlmittel bewegt sich somit von der Betriebseinheit 10 zu den elektrischen Versorgungseinheiten 3a - 3f, zum Abgabebereich 5 und zurück zur Betriebseinheit 10, so dass der Kreislauf des Kühlmittels geschlossen ist. Das Kühlmittel wird somit vom zweiten Ende 9 der Textilmaschine 1 zum ersten Ende 8 der Textilmaschine 1 und wieder zurück zum zweiten Ende 9 der Textilmaschine 1 transportiert.

Durch die Strömungsrichtung KR ist ebenfalls eine Transportrichtung der Abwärme ausgebildet. Die Abwärme wird von den mehreren Wärmeaufnahmestellen, die entlang der Längsrichtung der Textilmaschine 1 nebeneinander angeordnet sind und vorliegend jeweils durch die elektrischen Versorgungseinheiten 3a - 3f gebildet sind, bis an das erste Ende 8 der Textilmaschine 1 geführt.

Gemäß dem vorliegenden Ausführungsbeispiel weist der Kühlmittelkreislauf 16 eine Zuleitung 17 auf, die von der Betriebseinheit 10 zu den elektrischen Versorgungseinheiten 3a - 3f führt. Die Zuleitung 17 führt das Kühlmittel nacheinander zu den elektrischen Versorgungseinheiten 3a - 3f und nimmt dementsprechend der Reihenfolge nach von jeder elektrischen Versorgungseinheit 3a - 3f die Abwärme auf. Das Kühlmittel kann sich dabei von elektrischer Versorgungseinheit 3a - 3f zu elektrischer Versorgungseinheit 3a - 3f erwärmen, wobei es an jeder Versorgungseinheit 3a - 3f eine bestimmte Wärmemenge aufnimmt und sich somit jeweils um ein bestimmtes Temperaturdelta erhöht.

In Strömungsrichtung KR nach der letzten elektrischen Versorgungseinheit 3a - 3f wird das Kühlmittel zum Abgabebereich 5 geführt, wo es die Abwärme abgibt. Dies kann beispielsweise durch den hier gezeigten Wärmetauscher 6 und gegebenenfalls durch den Lüfter 15 geschehen. Die Abwärme kann an den Abführkanal 7 abgegeben werden, der die Abwärme beispielsweise aus dem Gebäude der Textilmaschine abführt.

Nachdem das Kühlmittel die Abwärme im Abgabebereich 5 abgegeben hat, wobei sich das Kühlmittel abgekühlt haben kann, kann es in einer Rückleitung 18 zur Betriebseinheit 10 zurückgeführt werden. Vorteilhaft dabei ist es, dass aufgrund der Länge der Rückleitung 18, die sich vorzugsweise entlang sämtlicher Arbeitsstellen der Textilmaschine erstreckt, auch die Rückleitung 18 noch für die Wärmeabgabe an die Umgebung genutzt werden kann. Dies gilt selbstverständlich auch für das folgende Ausführungsbeispiel.

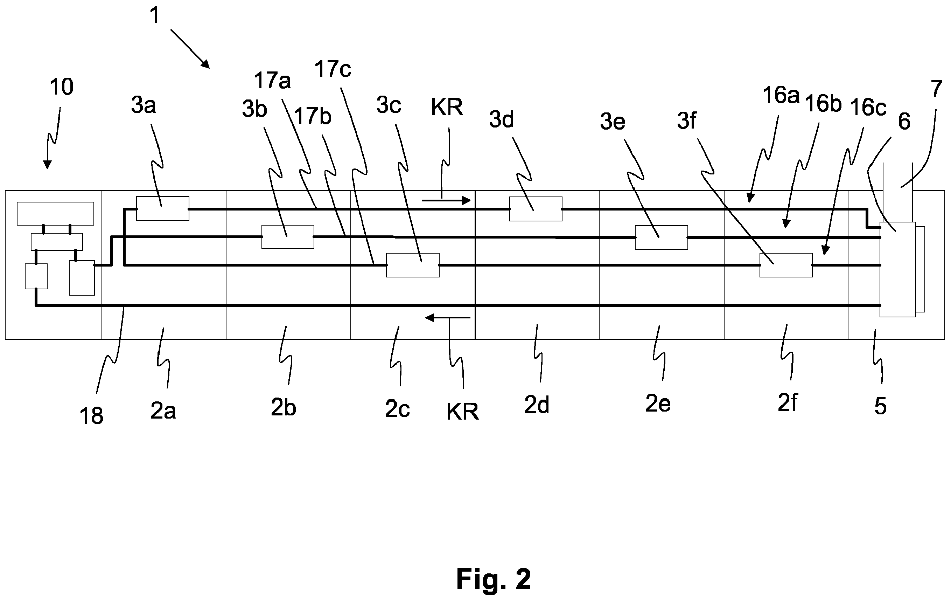

Figur 2 zeigt eine schematische Ansicht einer Textilmaschine 1 mit einer Kühlanordnung 4 für elektrische Versorgungseinheiten 3a - 3f mit mehreren Kühlmittelkreisläufen 16a - 16c. Der Einfachheit halber werden hier nur noch die relevanten Merkmale und/oder gegenüber der Figur 1 neuen Merkmale mit einem Bezugszeichen versehen und im Folgenden näher beschrieben.

Die Textilmaschine 1 des vorliegenden Ausführungsbeispiels weist drei Kühlmittelkreisläufe 16a - 16c auf, welche die Abwärme der elektrischen Versorgungseinheiten 3a - 3f aufnehmen und abführen bzw. abtransportieren können. Die Kühlmittelkreisläufe 16a - 16c sind dabei derart angeordnet bzw. führen die Abwärme derjenigen elektrischen Versorgungseinheiten 3a - 3f so ab, dass ein erster Kühlmittelkreislauf 16a die Abwärme der in diesem Ausführungsbeispiel mit dem Bezugszeichen 2a und 2d bezeichneten Sektionen bzw. der Energieversorgungseinheiten 3a und 3d abtransportiert. Ein zweiter Kühlmittelkreislauf 16b transportiert die Abwärme der Sektionen 2b und 2e bzw. der Energieversorgungseinheiten 3b und 3e ab. Ein dritter Kühlmittelkreislauf 16c transportiert die Abwärme der Sektion 2c und 2f bzw. der Energieversorgungseinheiten 3c und 3f ab.

Der erste Kühlmittelkreislauf 16a kann somit von der Betriebseinheit 10 aus gesehen die Abwärme der ersten, der vierten, der siebten, der zehnten, usw. (bei mehr als den hier gezeigten sechs elektrischen Versorgungseinheiten 3a - 3f) abtransportieren.

Der zweite Kühlmittelkreislauf 16b kann somit von der Betriebseinheit 10 aus gesehen die Abwärme der zweiten, der fünften, der achten, der elften, usw. (bei mehr als den hier gezeigten sechs elektrischen Versorgungseinheiten 3a - 3f) abtransportieren.

Der dritte Kühlmittelkreislauf 16c kann somit von der Betriebseinheit 10 aus gesehen die Abwärme der dritten, der sechsten, der neunten, der zwölften, usw. (bei mehr als den hier gezeigten sechs elektrischen Versorgungseinheiten 3a - 3f) abtransportieren.

Wenn somit N-Kühlmittelkreisläufe vorhanden sind, transportiert ein n-ter Kühlmittelkreislauf 16 somit die Abwärme der n-ten, der n+N-ten, der n+2N-ten, der n+3N-ten, usw. elektrischen Versorgungseinheit 3 ab. Dadurch können die mehreren Kühlmittelkreisläufe 16 die Abwärme gleichmäßig abtransportieren bzw. wird dadurch die Abwärme gleichmäßig auf die Kühlmittelkreisläufe 16 verteilt. Es kann damit beispielsweise verhindert werden, dass ein Kühlmittelkreislauf 16 die meiste Abwärme abtransportiert und die anderen Kühlmittelkreisläufe 16 nur verhältnismäßig wenig Abwärme abtransportieren.

Gemäß dem vorliegenden Ausführungsbeispiel weisen die hier gezeigten drei Kühlmittelkreisläufe 16a - 16c jeweils eine Zuleitung 17a - 17c auf. Die drei Kühlmittelkreisläufe 16a - 16c weisen dagegen nur eine Rückleitung 18 auf. Die drei Zuleitungen 17a - 17c werden in dem zentralen Wärmetauscher 6 zusammengeführt und nach der Wärmeabgabe der gemeinsamen Rückleitung 18 zugeführt.

Die Zuleitungen 17a - 17c und die Rückleitung 18 können dabei vorteilhaft unterhalb der Arbeitsstellen in den Sektionen 2a - 2f, insbesondere an oder in einem Sektionsverteilerkasten, angeordnet sein, wo sie beispielsweise für Wartungsarbeiten gut zugänglich sind.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Textilmaschine
- 2: Sektion
- 3: elektrische Versorgungseinheit
- 4: Kühlanordnung
- 5: Abgabebereich
- 6: Wärmetauscher
- 7: Abführkanal
- 8: erstes Ende
- 9: zweites Ende
- 10: Betriebseinheit
- 11: Pumpe
- 12: Kühlmittelreservoir
- 13: Steuerventile
- 14: Luftabscheider
- 15: Lüfter
- 16: Kühlmittelkreislauf
- 17: Zuleitung
- 18: Rückleitung

- KR: Strömungsrichtung

## Patentansprüche

1. Textilmaschine (1), insbesondere Rotorspinnmaschine, mit einer Vielzahl an in einer Längsrichtung der Textilmaschine (1) nebeneinander angeordneten Arbeitsstellen, insbesondere Spinn- und/oder Spulstellen, welche zu mehreren Sektionen (2a - 2f) zusammengefasst sind, wobei die Textilmaschine (1) mehrere elektrische Versorgungseinheiten (3a - 3f) aufweist, mittels welcher die Arbeitsstellen und/oder die Sektionen (2a - 2f) mit elektrischer Energie versorgbar sind, und wobei die Textilmaschine (1) eine zumindest einen Kühlmittelkreislauf (16a - 16c) umfassende Kühlanordnung (4) aufweist, mittels der eine Abwärme der elektrischen Versorgungseinheiten (3a - 3f) aufnehmbar ist und zu einem Abgabebereich (5) der Textilmaschine (1) transportierbar ist, **dadurch gekennzeichnet, dass**
die Kühlanordnung (4) derart ausgebildet ist, dass mittels des wenigstens einen Kühlmittelkreislaufs (16a - 16c) die Abwärme mehrerer der elektrischen Versorgungseinheiten (3a - 3f) zu einem gemeinsamen Abgabebereich (5) der Textilmaschine (1) transportierbar ist.

2. Textilmaschine nach dem vorhergehenden Anspruch, **dadurch gekennzeichnet, dass** im Abgabebereich (5) ein Wärmetauscher (6) der Kühlanordnung (4) angeordnet ist, mittels dem die Abwärme an eine Umgebung und/oder einen Abführkanal (7), insbesondere einen Abführkanal (7), der Textilmaschine (1) abgebbar ist.

3. Textilmaschine nach einem der vorhergehenden Ansprüche, **dadurch gekennzeichnet, dass** der Abgabebereich (5) innerhalb der Textilmaschine (1) angeordnet ist.

4. Textilmaschine nach einem der vorhergehenden Ansprüche, **dadurch gekennzeichnet, dass** der Textilmaschine (1) ein externes Kühlsystem zugeordnet ist und die Abwärme im Abgabebereich (5) an das externe Kühlsystem übergebbar ist.

5. Textilmaschine nach einem der vorhergehenden Ansprüche, **dadurch gekennzeichnet, dass** die elektrischen Versorgungseinheiten (3a - 3f) Netzteile und/oder Frequenzumrichter beinhalten.

6. Textilmaschine nach einem der vorhergehenden Ansprüche, **dadurch gekennzeichnet, dass** jede der Sektionen (2a - 2f) jeweils eine elektrische Versorgungseinheit (3a - 3f), insbesondere ein Netzteil, zur Energieversorgung der jeweiligen Sektion (2a - 2f) und der ihr zugeordneten Arbeitsstellen aufweist.

7. Textilmaschine nach einem der vorhergehenden Ansprüche, **dadurch gekennzeichnet, dass** der zumindest eine Kühlmittelkreislauf (16a - 16c) alle elektrischen Versorgungseinheiten (3a - 3f) der Textilmaschine (1) verbindet und deren Abwärme zu einem einzigen, gemeinsamen Abgabebereich (5) transportierbar ist.

8. Textilmaschine nach einem der vorhergehenden Ansprüche, **dadurch gekennzeichnet, dass** der Abgabebereich (5) an einem ersten Ende (8) der Textilmaschine (1), insbesondere in einem ersten Endgestell der Textilmaschine (1), angeordnet ist.

9. Textilmaschine nach einem der vorhergehenden Ansprüche, **dadurch gekennzeichnet, dass** wenigstens zwei Abgabebereiche (5) an der Textilmaschine (1) angeordnet sind, wobei vorzugsweise ein Abgabebereich (5) an dem ersten Ende (8) der Textilmaschine (1), insbesondere in einem ersten Endgestell der Textilmaschine (1), und ein Abgabebereich (5) an einem zweiten Ende (9) der Textilmaschine (1), insbesondere in einem zweiten Endgestell der Textilmaschine (1), angeordnet ist.

10. Textilmaschine nach einem der vorhergehenden Ansprüche, **dadurch gekennzeichnet, dass** die Kühlanordnung (4) eine Betriebseinheit (10) umfasst, welche vorzugsweise an einem dem Abgabebereich (5) gegenüberliegenden, zweiten Ende (9) der Textilmaschine (1), insbesondere in einem zweiten Endgestell der Textilmaschine (1), angeordnet ist.

11. Textilmaschine nach einem der vorhergehenden Ansprüche, **dadurch gekennzeichnet, dass** die Sektionen (2a - 2f) und/oder die Arbeitsstellen weitere Abwärmequellen aufweisen, welche an den wenigstens einen Kühlmittelkreislauf (16a - 16c) angeschlossen sind.

12. Textilmaschine nach einem der vorhergehenden Ansprüche, **dadurch gekennzeichnet, dass** die Kühlanordnung (4) mehrere Kühlmittelkreisläufe (16a - 16c) aufweist, wobei die elektrischen Versorgungseinheiten (3a - 3f) und/oder die weiteren Abwärmequellen derart an die mehreren Kühlmittelkreisläufe (16a - 16c) angeschlossen sind, dass eine Abwärmeaufnahme der mehreren Kühlmittelkreisläufe (16a - 16c) jeweils gleich ist.

13. Textilmaschine nach einem der vorhergehenden Ansprüche, **dadurch gekennzeichnet, dass** die Kühlanordnung (4) mehrere Kühlmittelkreisläufe (16a - 16c) mit der Anzahl N aufweist, wobei mittels des ersten Kühlmittelkreislaufs (16a - 16c) die Abwärme der 1-ten, der N+1-ten, der 2N+1-ten, der 3N+1-ten, usw. elektrischen Versorgungseinheit (3a - 3f) aufnehmbar ist, mittels des zweiten Kühlmittelkreislaufs (16a - 16c) die Abwärme der 2-ten, der N+2-ten, der 2N+2-ten, der 3N+2-ten, usw. elektrischen Versorgungseinheit (3a - 3f) aufnehmbar ist, mittels des dritten Kühlmittelkreislaufs (16a - 16c) die Abwärme der 3-ten, der N+3-ten, der 2N+3-ten, der 3N+3-ten, usw. elektrischen Versorgungseinheit (3a - 3f) aufnehmbar ist, usw.

14. Textilmaschine nach einem der vorhergehenden Ansprüche, **dadurch gekennzeichnet, dass** die mehreren Kühlmittelkreisläufe (16a - 16c) mehrere Zuleitungen (17) und eine gemeinsame Rückleitung (18) aufweisen.

15. Textilmaschine nach einem der vorhergehenden Ansprüche, **dadurch gekennzeichnet, dass** sich die Zuleitung(en) (17) und/oder die Rückleitung (18) entlang der Längsrichtung der Textilmaschine (1) erstrecken.

16. Textilmaschine nach einem der vorhergehenden Ansprüche, **dadurch gekennzeichnet, dass** die elektrischen Versorgungseinheiten (3a - 3f) eine vorzugsweise in ein Gehäuse der Versorgungseinheiten (3a - 3f) integrierte Kühleinheit aufweisen, wobei der wenigstens eine Kühlmittelkreislauf (16a - 16c), insbesondere die Zuleitung(en) (17) des wenigstens einen Kühlmittelkreislaufs (16a - 16c) vorzugsweise mäanderförmig durch diese hindurchführt.
